# EUROPÄISCHE PATENTSCHRIFT

(11) **EP 2 460 241 B1**
(45) Veröffentlichungstag und Bekanntmachung des Hinweises auf die Patenterteilung: **07.08.2013**
(21) Anmeldenummer: 10740507.8
(22) Anmeldetag: 28.06.2010
(51) Int. Cl.: H01S 5/40, H01S 5/22

(54) **BREITSTREIFENLASER MIT EINEM EPITAKTISCHEN SCHICHTENSTAPEL UND VERFAHREN ZU DESSEN HERSTELLUNG**
BROAD STRIPE LASER HAVING AN EPITAXIAL LAYER STACK AND METHOD FOR PRODUCING THE SAME
LASER À RUBAN LARGE AVEC EMPILEMENT DE COUCHES ÉPITAXIALES ET MÉTHODE DE FABRICATION

(30) Priorität: 31.07.2009 DE 102009035639
(43) Veröffentlichungstag der Anmeldung: 06.06.2012
(73) Patentinhaber: OSRAM Opto Semiconductors GmbH, 93055 Regensburg (DE)
(72) Erfinder: LELL, Alfred, 93142 Maxhütte - Haidhof (DE); RAMMELSBERGER, Stefanie, 93197 Zeitlarn (DE)
(74) Vertreter: Epping - Hermann - Fischer
(86) Internationale Anmeldenummer: PCT/DE2010/000751
(87) Internationale Veröffentlichungsnummer: WO 2011/012100

(56) Entgegenhaltungen:
- GB-A- 2 180 690
- GB-A- 2 388 958
- JP-A- 1 175 281
- JP-A- 2007 157 906
- US-A- 4 400 813
- US-A- 5 299 219
- US-A1- 2009 092 163

## Beschreibung

Die vorliegende Erfindung betrifft einen Breitstreifenlaser mit einem epitaktischen Schichtenstapel, der eine aktive, strahlungserzeugende Schicht enthält. Weiterhin betrifft die Erfindung ein Verfahren zum Herstellen eines derartigen Breitstreifenlasers.

Halbleiterlaser finden aufgrund ihrer Kompaktheit und kostengünstigen Herstellung Anwendung in zahlreichen Applikationsbereichen, wie beispielsweise Datenübertragung, Datenspeicherung, Projektion, Materialbearbeitung, optisches Pumpen, Biosensorik und ähnliches. Insbesondere Halbleiterlaser basierend auf dem AlInGaN-Materialsystem bieten aufgrund ihrer erzeugten Strahlung im UV- bis Blaubeziehungsweise grünen Wellenlängenbereich vielfältige Einsatzmöglichkeiten. In den meisten Anwendungsgebieten kommt es dabei auf eine hohe optische Ausgangsleistung beziehungsweise Ausgangsleistungsdichte des Halbleiterlasers an.

Jedoch ist bei Halbleiterlasern die Ausgangsleistung aufgrund thermischer Effekte begrenzt. Beispielsweise ist bei sogenannten "Single-Emittern" die Ausgangsleistung auf wenige 100 Milliwatt im cw-Betrieb begrenzt.

Optische Ausgangsleistungen können unter anderem durch Steigerung der Effizienz des Halbleiterlasers, beispielsweise mit Hilfe eines optimierten Epitaxiedesigns der Schichten des Halbleiterlasers erhöht werden. Allerdings ist auch hierbei die Ausgangsleistung derartiger Halbleiterlaser aufgrund thermischer Effekte auf wenige 100 Milliwatt im cw-Betrieb begrenzt.

Leistungssteigernde Maßnahmen können ferner beispielsweise durch den gleichzeitigen Betrieb mehrerer Laserdioden ermöglicht werden.

Zusätzlich besteht bei Breitstreifenlasern durch die so genannte "thermische Linse", die das Einschnüren der Lasermode des Lasers auf wenige µm bei hohen Strömen bewirkt, die Gefahr, die oberseitig angeordneten Stege bei hohen Stromdichten zu beschädigen oder gar zu zerstören.

Die Druckschrift GB 2 180 690 A betrifft ein Halbleiterlaserarray.

In der Druckschrift US 2009/0092163 A1 ist eine Laserdiode und eine Herstellungsmethode hierfür angegeben.

Ein Streifendiodenlaser findet sich n der Druckschrift US 5,299,219 A.

Die Beschreibung eines Halbleiterlasers ist in der Druckschrift JP 2007-157906 A wiedergegeben.

In der Druckschrift US 4,400,813 A ist ein Laser mit einem Streifenwellenleiter offenbart.

Der Druckschrift GB 2 388 958 A ist ein optisches Bauteil zu entnehmen.

Eine Halbleiterlaseranordnung ist aus der Druckschrift JP 01-175281 A bekannt.

Der Erfindung liegt die Aufgabe zugrunde, einen verbesserten Breitstreifenlaser anzugeben, der insbesondere eine verbesserte optische Leistungsdichte, eine gesteigerte Effizienz bei hohen Leistungen und eine verbesserte Lebensdauer aufweist. Ferner liegt der Erfindung die Aufgabe zugrunde, ein verbessertes, insbesondere vereinfachtes Herstellungsverfahren eines derartigen Breitstreifenlasers anzugeben.

Diese Aufgaben werden durch einen Breitstreifenlaser mit den Merkmalen des Patentanspruchs 1 und ein Verfahren zu dessen Herstellung mit den Merkmalen des Patentanspruchs 15 gelöst.

Erfindungsgemäß ist ein Breitstreifenlaser mit einem epitaktischen Schichtenstapel vorgesehen, der eine aktive, strahlungserzeugende Schicht enthält und eine Oberseite und eine Unterseite aufweist. Der Schichtenstapel weist Gräben auf, in denen wenigstens eine Schicht des Schichtenstapels zumindest teilweise entfernt ist und die von der Oberseite in Richtung Unterseite führen. Der Schichtenstapel weist ferner oberseitig Stege auf, die jeweils an die Gräben angrenzen, sodass der Schichtenstapel oberseitig streifenförmig ausgebildet ist. Die Stege und die Gräben weisen jeweils eine Breite von höchstens 20 µm auf. Bevorzugt weisen die Stege und die Gräben jeweils eine Breite von höchstens 10 µm, besonders bevorzugt von höchstens 7 µm auf.

Ein derartiger Breitstreifenlaser weist demnach oberseitig vorzugsweise indexgeführte, eng benachbarte Einzelstreifen, sogenannte Stege, mit einer Breite von weniger als 20 µm, bevorzugt von weniger als 10 µm, besonders bevorzugt von weniger als 7 µm auf. Benachbarte Stege weisen dabei einen Abstand von höchstens 20 µm, bevorzugt von höchstens 10 µm zueinander auf.

Der erfindungsgemäße Breitstreifenlaser weist somit nicht, wie herkömmlicherweise oberseitig lediglich einen Breitstreifen auf. Insbesondere ist der Breitstreifen des Lasers erfindungsgemäß in Einzelstreifen, den sogenannten Stegen, aufgespalten.

Derartige Breitstreifenlaser weisen mit Vorteil eine verbesserte, insbesondere gesteigerte optische Ausgangsleistung und Ausgangsleistungsdichte bei gleichzeitig verringerter Facettenbelastung auf. Weiter erhöht sich so mit Vorteil die Lebensdauer derartiger Breitstreifenlaser, wobei diese gleichzeitig ein auf die jeweilige Applikation hin optimiertes Strahlprofil aufweisen können. Zusätzlich ermöglicht der erfindungsgemäße Breitstreifenlaser mit Vorteil, die Abstrahlcharakteristik gezielt zwischen Vorwärtsstrahlung, Gaußprofil und Rechteckprofil oder Mischungen daraus einzustellen.

Insbesondere gelingt es mittels eines derartigen Breitstreifenlasers, die Abstrahlcharakteristik gezielt zu formen durch eine kontrollierte Steuerung der
- Einzelemitterdichte, insbesondere einstellbar über den jeweiligen Abstand der Stege,
- Laserschwellströme, beispielsweise durch Steuerung der Stromaufweitung über Indexführung und/oder eine unterschiedliche Breite der einzelnen Stege, und
- Steilheit, beispielsweise durch Steuerung der Verluste,
- oder Kombinationen hieraus.

Bevorzugt basiert der Breitstreifenlaser, insbesondere der epitaktische Schichtenstapel des Breitstreifenlasers, auf InGaN, besonders bevorzugt auf InGaAlN. Vorzugsweise ist der Breitstreifenlaser ein Kantenemitter. Bevorzugt ist der Breitstreifenlaser ein Halbleiterlaser.

Bei einer bevorzugten Ausgestaltung des Breitstreifenlasers ist zumindest eine Schicht des Schichtenstapels auf der der Unterseite zugewandten Seite der aktiven, strahlungserzeugenden Schicht n-dotiert und zumindest eine Schicht des Schichtenstapels auf der der Oberseite zugewandten Seite der aktiven, strahlungserzeugenden Schicht p-dotiert.

Bevorzugt sind alle Schichten des Schichtenstapels auf der der Unterseite zugewandten Seite der aktiven, strahlungserzeugenden Schicht n-dotiert oder undotiert und alle Schichten des Schichtenstapels auf der der Oberseite zugewandten Seite der aktiven, strahlungserzeugenden Schicht p-dotiert oder undotiert.

Die Gräben des Breitstreifenlasers sind vorzugsweise in der p-dotierten Schicht oder den p-dotierten Schichten des Schichtenstapels ausgebildet.

Bevorzugt durchdringen die Gräben die aktive Schicht des Schichtenstapels des Breitstreifenlasers nicht. In diesem Fall sind die Gräben somit lediglich oberseitig des Schichtenstapels ausgebildet.

Alternativ können die Gräben die aktive Schicht durchdringen. In diesem Fall sind die Gräben in allen Schichten des Schichtenstapels, die sich auf der der Oberseite zugewandten Seite der aktiven, strahlungserzeugenden Schicht befinden, sowie in der aktiven, strahlungserzeugenden Schicht ausgebildet.

Vorzugsweise weisen die Stege jeweils eine gleiche Höhe auf.

Bei einer bevorzugten Ausgestaltung des Breitstreifenlasers weisen die Gräben jeweils eine gleiche Tiefe auf. Alternativ können die Gräben zumindest teilweise eine unterschiedliche Tiefe aufweisen.

Beispielsweise ist die Gräbentiefe zwischen den Stegen geringer als außerhalb des ursprünglichen Breitstreifens. Dadurch kann der stärkeren Facettenbelastung der mittleren Stege durch eine höhere Stromaufweitung entgegengewirkt werden. Bevorzugt verläuft der Tiefenunterschied der Gräben stufenförmig.

Alternativ kann die indexdefinierende Gräbentiefe zwischen den Stegen höher sein als außerhalb des ursprünglichen Breitstreifens. Dadurch kann mit Vorteil über die tiefenabhängige Steilheit der Gräben gezielt das Strahlprofil des Breitstreifenlasers gesteuert werden.

Bei einer bevorzugten Ausgestaltung des Breitstreifenlasers sind benachbarte Stege jeweils in einem gleichen Abstand zueinander angeordnet.

Alternativ können benachbarte Stege zumindest teilweise in einem unterschiedlichen Abstand zueinander angeordnet sein. Vorzugsweise weisen benachbarte innere Stege einen größeren Abstand zueinander auf als benachbarte äußere Stege. Dadurch kann der unterschiedlichen thermischen Belastung der Stege entgegengewirkt werden.

Bei einer bevorzugten Ausgestaltung des Breitstreifenlasers weisen die Stege zumindest teilweise eine unterschiedliche Breite auf.

Bevorzugt weisen innere Stege eine größere Breite auf als äußere Stege. Dadurch kann einem unterschiedlichen Anschwingen, das insbesondere bedingt ist durch eine unterschiedliche thermische Belastung, entgegengewirkt werden, wodurch das Strahlprofil mit Vorteil gezielt beeinflusst wird.

Bei dem Breitstreifenlaser weisen die Gräben jeweils eine Grundfläche auf, die jeweils eine Krümmung aufweist. Der Tiefenunterschied der Gräben verläuft vorzugsweise graduell. So kann mit Vorteil der stärkeren Facettenbelastung der mittleren Stege durch eine höhere Stromaufweitung entgegengewirkt werden.

Die Krümmungen der Grundflächen der Gräben sind vorzugsweise linsenförmig ausgebildet. Bevorzugt bilden die Grundflächen der Gräben zusammen eine konvexe Linsenform aus.

Bei einer bevorzugten Ausgestaltung des Breitstreifenlasers ist jeweils auf den Stegen zumindest bereichsweise eine Anschlussschicht angeordnet.

Beispielsweise kann die Anschlussschicht eine von der aktiven Schicht abgewandte Seite der Stege vollständig bedecken. Alternativ kann die Anschlussschicht auf den Stegen jeweils strukturiert ausgebildet sein.

Vorzugsweise ist die Anschlussschicht auf den Stegen jeweils als von zwei sich gegenüberliegenden Kanten des Schichtenstapels zurückgezogene Anschlussschicht ausgebildet. Ferner kann die Anschlussschicht auf den Stegen jeweils als mit einer oder mehreren Öffnungen versehene Anschlussschicht ausgebildet sein. Die Öffnungen der Anschlussschicht können sich dabei quer zu dem jeweiligen Steg oder entlang des jeweiligen Steges erstrecken. Dadurch können gezielt Bereiche mit höherer Absorption erzeugt werden.

In Bereichen der Öffnungen der Anschlussschicht können bei einer weiteren bevorzugten Ausgestaltung des Breitstreifenlasers weitere Gräben angeordnet sein, die sich bereichsweise vertikal in die jeweiligen Stege erstrecken, diese jedoch nicht vollständig durchdringen.

Bei einer weiteren bevorzugten Ausgestaltung des Breitstreifenlasers ist zwischen den Stegen und der Anschlussschicht bereichsweise eine Passivierungsschicht angeordnet. Die Passivierungsschicht ist vorzugsweise elektrisch isolierend ausgebildet. In Bereichen der Passivierungsschicht liegt somit kein elektrischer Kontakt zwischen den Schichten der Stege und der Anschlussschicht vor. Die Anschlussschicht kann dabei ganzflächig ausgebildet sein, wobei der elektrische Anschluss zwischen der Anschlussschicht und dem Schichtenstapel aufgrund der Passivierungsschicht nicht ganzflächig ausgebildet ist.

vorzugsweise ist auf der Oberseite des epitaktischen Schichtenstapels eine dielektrische Passivierung angeordnet, wobei auf den Stegen keine dielektrische Passivierung angeordnet ist. In Bereichen auf den Stegen weist die dielektrische Passivierung somit jeweils eine Aussparung auf. Bevorzugt ist die dielektrische Passivierung als Schicht ausgebildet.

Vorzugsweise enthält die Passivierungsschicht und/oder die dielektrische Passivierung Siliziumdioxid (SiO₂), Siliziumnitrid (SiN), Aluminiumoxid (Al₂O₃), Hafniumoxid (HfO₂), Zirconiumoxid (ZrO₂) oder Tantaloxid (Ta₂O₅).

Bei einer weiteren bevorzugten Ausgestaltung ist eine Mehrzahl von Breitstreifenlasern nebeneinander als voneinander getrennte Arrays angeordnet, wobei die Abstände zwischen benachbarten Arrays jeweils vorzugsweise größer als 20 µm sind.

Bei einer weiteren bevorzugten Ausführungsform des Breitstreifenlasers ist dem Laser in Abstrahlrichtung eine optische Linse oder ein Linsensystem nachgeordnet. Ein erfindungsgemäßer Breitstreifenlaser, der eine kontrollierte Abstrahlcharakteristik aufweist, kann mit Vorteil mit einer optischen Linse oder einem entsprechendem Linsensystem derart kombiniert sein, dass eine gewünschte Abbildungseigenschaft erzielt wird.

Ein erfindungsgemäßes Verfahren zum Herstellen eines Breitstreifenlasers umfasst insbesondere die folgenden Schritte:
a) Epitaktisches Aufwachsen eines Schichtenstapels auf einem Aufwachssubstrat, wobei der Schichtenstapel eine Oberseite und eine Unterseite aufweist,
b) Oberseitiges Ätzen des Schichtenstapels an zwei sich gegenüberliegenden Kanten des Schichtenstapels derart, dass eine Breitstreifenlaserstruktur ausgebildet wird, und
c) Oberseitiges Ätzen von Gräben in den Schichtenstapel im Bereich der Breitstreifenlaserstruktur derart, dass Stege ausgebildet werden, die jeweils eine Breite von höchstens 20 µm, bevorzugt von höchstens 10 µm aufweisen, wobei benachbarte Stege einen Abstand von höchstens 20 µm, bevorzugt von höchstens 10 µm zueinander aufweisen.

Die herkömmlicherweise bekannte Breitstreifenlaserstruktur wird insbesondere in Einzelstreifen, insbesondere einzelne Stege aufgespalten. Durch eine unterschiedliche Breite der Stege und/oder durch eine unterschiedliche Indexführung des Strahlprofils kann die Ausgangsleistung auf die jeweilige Anwendung des Lasers hin optimiert werden. Somit ermöglichen sich eine verbesserte optische Ausgangsleistung, eine verbesserte Strahldichte und eine erhöhte Lebensdauern, wobei insbesondere eine gleichzeitig kontrollierbare Optimierung des Strahlprofils ermöglicht wird.

Weitere Merkmale, Vorteile, bevorzugte Ausgestaltungen und Zweckmäßigkeiten des Breitstreifenlasers und des Verfahrens zu dessen Herstellung ergeben sich aus den im Folgenden in Verbindung mit den Figuren 1 bis 13 erläuterten Ausführungsbeispielen. Es zeigen:
- Figuren 1, 3, 4, 8, 10, 11 und 12: jeweils einen schematischen Querschnitt einer Abwandlung eines Breitstreifenlasers,
- Figur 6: einen schematischen Querschnitt eines Ausführungsbeispiels eines erfindungsgemäßen Breitstreifenlasers,

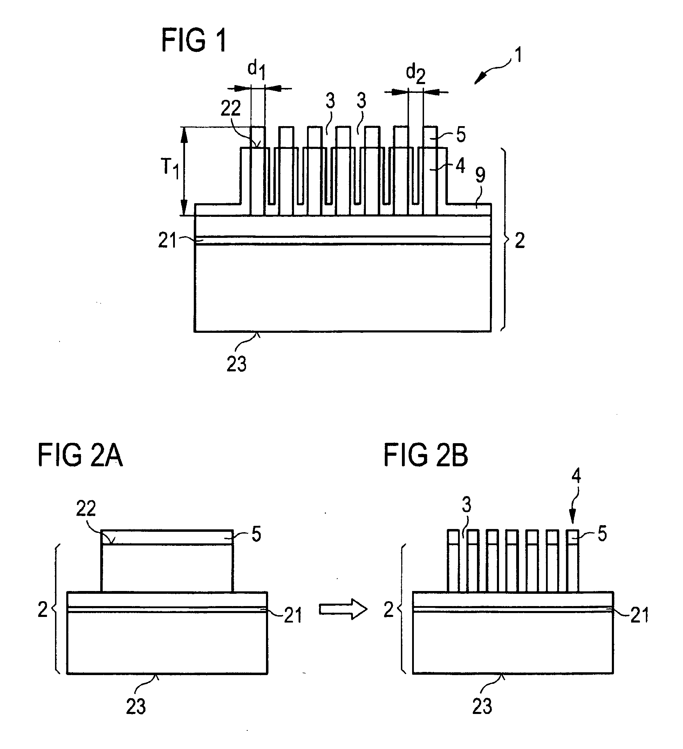

- Figuren 2, 5 und 9: jeweils ein Herstellungsverfahren zur Herstellung einer Abwandlung eines Breitstreifenlasers,

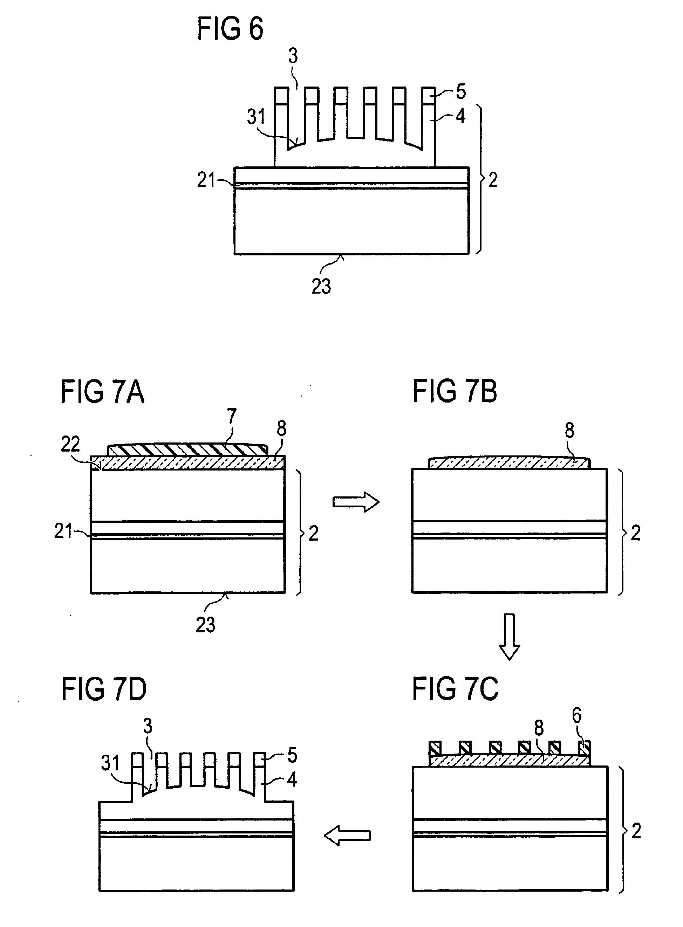

- Figur 7: ein erfindungsgemäßes Herstellungsverfahren zur Herstellung eines Ausführungsbeispiels eines Breitstreifenlasers, und

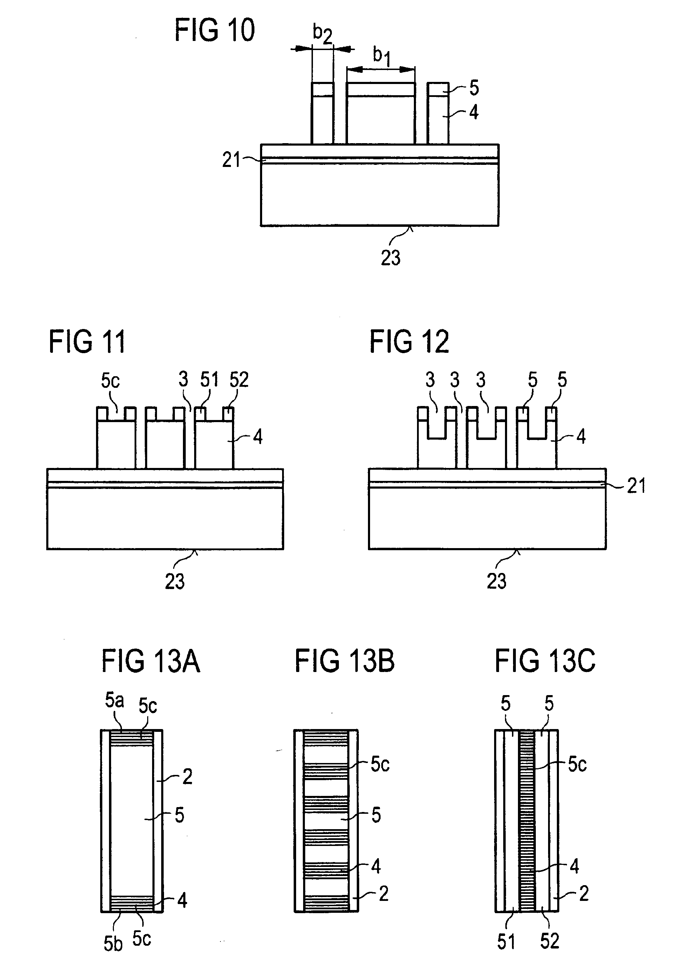

- Figur 13A bis 13C: jeweils eine Aufsicht auf ein Ausführungsbeispiel eines Steges eines erfindungsgemäßen Breitstreifenlasers.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

In Figur 1 ist ein schematischer Querschnitt einer Abwandlung eines Breitstreifenlasers dargestellt, der einen epitaktischen Schichtenstapel 2 mit einer aktiven, strahlungserzeugenden Schicht 21 aufweist. Insbesondere weist der Schichtenstapel 2 eine Oberseite 22 und eine Unterseite 23 auf. Der Schichtenstapel 2 kann beispielsweise auf einem Substrat oder einem Träger angeordnet sein (nicht dargestellt).

Vorzugsweise weisen die der Unterseite 23 zugewandten Schichten von der aktiven Schicht 21 gesehen eine n-Dotierung auf. Die Schichten des Schichtenstapels 2, die der Oberseite 22 von der aktiven Schicht 21 aus gesehen zugewandt sind, weisen vorzugsweise eine p-Dotierung auf. Als p-Dotierung kann beispielsweise Magnesium oder Zink Verwendung finden.

Der Laser ist insbesondere als Breitstreifenlasers 1 ausgebildet. Dabei ist die Laserstruktur so geätzt, dass oberseitig ein schmaler Streifen ausgebildet ist, wodurch mit Vorteil ein starkes Indexguiding durch den Brechungsindexsprung der Laserstruktur zu Luft vorliegt.

In der Abwandlung zu Figur 1 sind insbesondere die p-dotierten Schichten des Breitstreifenlasers bis auf einen schmalen Streifen entfernt, wodurch die Elektronen lateral eingeschränkt sind und eine Diffusion vermieden wird.

Der Schichtenstapel 2 weist weiter Gräben 3 auf, in denen wenigstens eine Schicht des Schichtenstapels zumindest teilweise entfernt ist und die von der Oberseite 22 in Richtung Unterseite 23 führen. Der Breitstreifenlaser 1 weist somit oberseitig weitere Ätzbereiche auf, wobei der Breitstreifen der Laserstruktur in Einzelstreifen, so genannte Stege, aufgespalten ist. Der Schichtenstapel 2, insbesondere der Breitstreifen des Breitstreifenlasers 1 ist oberseitig somit streifenförmig ausgebildet.

Die Stege 4 weisen vorzugsweise eine Breite von höchstens 20 µm, bevorzugt von höchstens 10 µm, besonders bevorzugt von höchstens 7 µm auf. Die Gräben 3, die benachbarte Stege 4 voneinander trennen, weisen jeweils eine Breite von höchstens 20 µm, bevorzugt von höchstens 10 µm auf. Somit weisen benachbarte Stege 4 jeweils einen Abstand von höchstens 20 µm, bevorzugt von höchstens 10 µm zueinander auf.

Durch die Aufspaltung des Breitstreifens des Lasers in Stege 4 kann mit Vorteil das Strahlprofil und die Ausgangsleistung auf die jeweilige Anwendung des Lasers hin optimiert werden. Insbesondere kann die Optimierung mittels einer unterschiedlichen Stegbreite und/oder einer unterschiedlichen Indexführung erzielt werden.

Der Breitstreifenlaser 1, dessen Breitstreifen in Stege 4 unterteilt ist, ermöglicht mit Vorteil eine verbesserte optische Ausgangsleistung, eine verbesserte Strahldichte und eine verlängerte Lebensdauer. Insbesondere ermöglicht sich gleichzeitig eine kontrollierbare Optimierung des Strahlprofils. Weiter steigert sich mit Vorteil die Effizienz bei hohen Leistungen.

Insbesondere kann die Abstrahlcharakteristik eines derartigen Breitstreifenlasers gezielt geformt werden durch beispielsweise eine kontrollierte Steuerung der Einzelemitterdichte (Abstand der Stege), der Laserschwellströme (beispielsweise durch Steuerung der Stromaufweitung über Indexführung und/oder über die unterschiedliche Stegbreite der Einzelemitter), und/oder der Steilheit (beispielsweise über Steuerung der Verluste) oder Kombinationen daraus.

Vorzugsweise ist der in Figur 1 dargestellte Breitstreifenlaser 1 ein Kantenemitter.

Die Gräben 3 des Breitstreifenlasers 1 werden beispielsweise mittels eines Ätzprozesses hergestellt. Die Ätztiefe T₁ in dem Ausführungsbeispiel der Figur 1 ist insbesondere derart ausgebildet, dass die aktive Schicht 21 nicht geätzt wird, insbesondere keine Gräben 3 durch die aktive Schicht 21 geführt sind. Alternativ können die Gräben 3 die aktive Schicht 21 durchdringen (nicht dargestellt).

In der Abwandlung der Figur 1 weisen die Gräben 3 jeweils eine gleiche Tiefe T₁ auf. Die Gräbenbreite d₂ beträgt höchstens 20 µm. Insbesondere beträgt der Abstand zwischen zwei benachbarten Stegen 4 so höchstens 20 µm. Die Stege 4 weisen eine Breite d₁ von höchstens 20 µm, vorzugsweise 10 µm auf.

Auf der Oberseite 22 des Schichtenstapels 2 ist vorzugsweise eine dielektrische Passivierung 9 angeordnet, wobei auf den Stegen 4 keine dielektrische Passivierung 9 angeordnet ist. In Bereichen auf den Stegen 4 weist die dielektrische Passivierung 9 somit jeweils eine Aussparung auf. Bevorzugt ist die dielektrische Passivierung 9 als Schicht ausgebildet.

Vorzugsweise enthält die dielektrische Passivierung 9 Siliziumdioxid (SiO₂), Siliziumnitrid (SiN), Aluminiumoxid (Al₂O₃), Hafniumoxid (HfO₂), Zirconiumoxid (ZrO₂ oder Tantaloxid (Ta₂O₅) .

In den weiteren Figuren 2 bis 13 ist die dielektrische Passivierung 9 jeweils der Übersicht halber nicht dargestellt. Jedoch findet die dielektrische Passivierung 9 auch in den weiteren Figuren 2 bis 13 Anwendung, auch wenn diese nicht explizit gezeigt ist.

Auf den Stegen 4 ist jeweils eine Anschlussschicht 5 angeordnet. In der Abwandlung der Figur 1 bedeckt die Anschlussschicht 5 die von der aktiven Schicht 21 abgewandte Seite der Stege jeweils vollständig. Die Anschlussschicht 5 ist somit vorzugsweise jeweils in den Aussparungen der dielektrischen Passivierung 9 angeordnet. Die Anschlussschicht 5 ist bevorzugt ebenso wie die Stege 4 streifenförmig ausgebildet, wobei die Anschlussschicht 5 in der Abwandlung der Figur 1 jeweils in Bereichen der Stege als durchgezogene Schicht ausgebildet ist. Vorzugsweise weist die Anschlussschicht 5 jeweils auf den Stegen keine Aussparungen oder Öffnungen auf.

Durch die Anschlussschicht 5 sind ebenso wie durch die Stege 4 die Gräben 3 geführt. Die Anschlussschicht 5 ist somit als strukturierte, insbesondere streifenförmige Anschlussschicht ausgebildet, wobei die Streifen der Anschlussschicht 5 mit den Stegen 4 zusammenfallen. Insbesondere weist lediglich die Seite der Stege 4, die von der aktiven Schicht 21 abgewandt ist, die Anschlussschicht 5 auf.

Die Anschlussschicht 5 weist vorzugsweise ein Metall oder eine Metalllegierung auf.

Der Breitstreifenlaser der Abwandlung der Figur 1 ermöglicht eine erhöhte optische Ausgangsleistung beziehungsweise Ausgangsleitungsdichte, wobei die Facettenbelastung des Lasers verringert ist, die Lebensdauer mit Vorteil erhöht ist und gleichzeitig ein auf die jeweilige Anwendung hin optimiertes Strahlprofil ermöglicht wird. Insbesondere ermöglicht ein derartig ausgebildeter Breitstreifenlaser es, die Abstrahlcharakteristik gezielt zwischen Vorwärtsstrahlung, Gaußprofil und Rechteckprofil oder Mischungen daraus einzustellen.

Vorzugsweise können derartige Breitstreifenlaser aufweisend eine kontrollierte Abstrahlcharakteristik in Kombination mit Linsen Verwendung finden (nicht dargestellt). Insbesondere kann mit einer optischen Linse oder einem entsprechenden Linsensystem eine gewünschte Abbildungseigenschaft erzielt werden.

In den Figuren 2A und 2B sind jeweils Herstellungsschritte zur Herstellung eines Breitstreifenlasers gemäß der Abwandlung der Figur 1 dargestellt. Insbesondere zeigt Figur 2A einen herkömmlichen Breitstreifenlaser, bei dem der Schichtenstapel 2 auf der Oberseite 22 derart entfernt ist, dass oberseitig ein Breitstreifen ausgebildet ist.

Vorzugsweise entsteht der Breitstreifen mittels eines ersten Ätzprozesses. Dabei wird die aktive Schicht 21 des Breitstreifenlasers vorzugsweise nicht geätzt.

Oberseitig weist der Schichtenstapel 2 eine Anschlussschicht 5 zur elektrischen Kontaktierung des Breitstreifenlasers auf. Unterseitig kann ein Substrat oder ein Träger angeordnet sein (nicht dargestellt), wobei unterseitig zur elektrischen Kontaktierung des Breitstreifenlasers bevorzugt eine weitere Anschlussschicht angeordnet ist (nicht dargestellt).

Nachfolgend der Herstellung der Breitstreifenlaserstruktur werden in dem oberseitig angeordneten Breitstreifen Gräben 3 geätzt, sodass der Breitstreifen in Stege 4 aufgespalten, beziehungsweise unterteilt ist, siehe Figur 2B. Die Stege 4 weisen dabei vorzugsweise eine Breite d₁ von höchstens 20 µm, besonders bevorzugt von höchstens 10 µm auf. Die Ätzbreite, also die Gräbenbreite d₂, weist vorzugsweise höchstens 20 µm, bevorzugt höchstens 10 µm auf. Zwei benachbarte Stege 4 sind insbesondere somit höchstens in einem Abstand von 20 µm, bevorzugt von höchstens 10 µm zueinander angeordnet. Die Ätztiefe T₁ der einzelnen Gräben 3 ist in dem Ausführungsbeispiel der Figuren 1 und 2 jeweils in etwa gleich groß. Insbesondere ist die Ätztiefe T₁ derart ausgebildet, dass die aktive Schicht 21 des Breitstreifenlasers nicht durchdrungen beziehungsweise geätzt ist.

Die herkömmlicherweise bekannte Breitstreifenlaserstruktur wird somit in der Abwandlung der Figur 2 mittels eines weiteren Ätzprozesses in mehrere gleich breite, äquidistante, gleich tief geätzte Stege 4 aufgespalten.

Alternativ können die Herstellung des Breitstreifens sowie die Herstellung der Stege 4, also die jeweiligen Ätzprozesse, in einem Ätzschritt erfolgen.

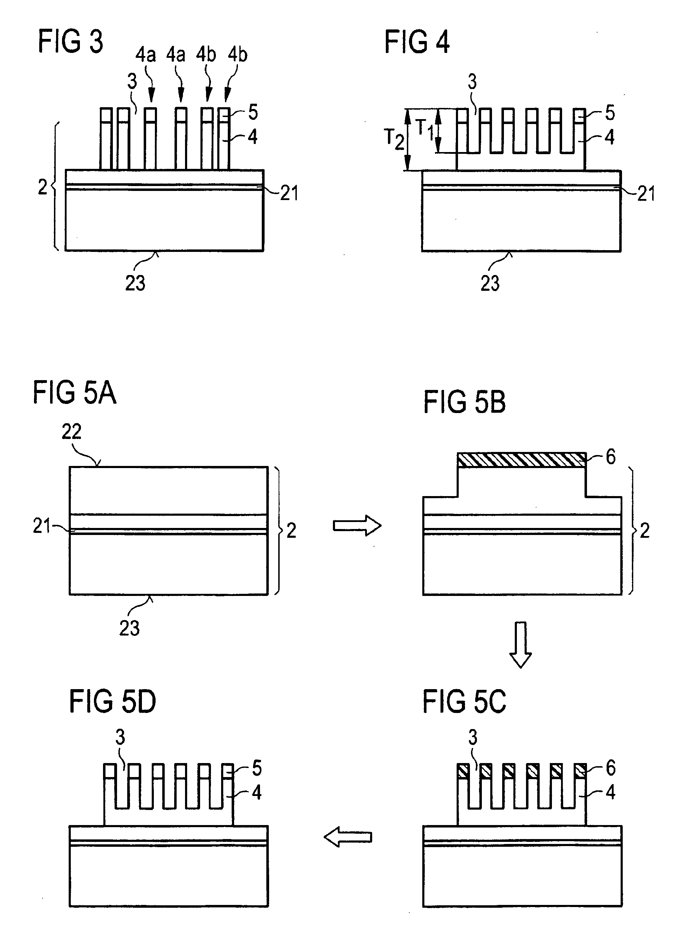

Die Abwandlung der Figur 3 unterscheidet sich von der Abwandlung der Figur 1 dadurch, dass benachbarte Stege 4 zumindest teilweise in einem unterschiedlichen Abstand zueinander angeordnet sind. Vorzugsweise weisen benachbarte innere Stege 4a einen größeren Abstand zueinander auf als benachbarte äußere Stege 4b. Der Abstand der Stege 4a, 4b zueinander weist jedoch höchstens 20 µm, vorzugsweise 10 µm auf. Durch die unterschiedlichen Abstände benachbarter Stege 4a, 4b kann der unterschiedlichen thermischen Belastung entgegengewirkt werden. Dadurch erhöht sich mit Vorteil die Lebensdauer eines derartigen Breitstreifenlasers.

Die Abwandlung der Figur 4 unterscheidet sich von der Abwandlung der Figur 1 dadurch, dass die Gräben 3 in der Breitstreifenstruktur des Lasers eine geringere Ätztiefe T₁ aufweisen. Insbesondere durchdringen die Gräben 3 die Breitstreifenstruktur des Lasers nicht vollständig. Die Tiefe T₂ der Breitstreifenstruktur des Lasers ist demnach größer als die Tiefe T₁ der Gräben 3.

Die Breitstreifenstruktur ist somit in mehrere gleich breite, äquidistante Stege 4 aufgespalten, wobei die indexdefinierende Ätztiefe T₁ zwischen den Stegen 4 geringer ist als außerhalb des ursprünglichen Breitstreifens, um der stärkeren Facettenbelastung der mittleren Stege durch eine höhere Stromaufweitung entgegenzuwirken. Der Ätztiefenunterschied T₁ zu T₂ verläuft vorzugsweise stufenförmig.

In den Figuren 5A bis 5D sind einzelne Herstellungsschritte zur Herstellung eines Breitstreifenlasers gemäß der Abwandlung der Figur 4 dargestellt.

In Figur 5A ist ein Schichtenstapel 2 aufweisend eine aktive, strahlungserzeugende Schicht 21, eine Oberseite 22 und eine Unterseite 23 gezeigt. An der Oberseite 22 wird, wie in Figur 5B dargestellt, mittels eines ersten Ätzprozesses eine Breitstreifenstruktur ausgebildet. Die Ätzungen führen vorzugsweise nicht durch die aktive Schicht 21. Der erste Ätzschritt erfolgt insbesondere mittels eines Fotolacks 6, der auf der Oberseite 22 des Lasers ausgebildet ist.

Alternativ kann der erste Ätzschritt an Stelle des Fotolacks mittels einer Ätzmaske erfolgen, die auf der Oberseite 22 des Lasers ausgebildet ist. Die Ätzmaske kann beispielsweise eine dielektrische oder metallische Hartmaske sein.

In einem weiteren Ätzprozess werden Gräben 3 in die Breitstreifenstruktur geätzt, wie in Figur 5C dargestellt. Dabei ist in diesem Fall die Ätztiefe der Gräben 3 geringer als die Ätztiefe der Breitstreifenstruktur.

Alternativ können die Herstellung des Breitstreifens sowie die Herstellung der Stege 4, insbesondere der erste Ätzprozess und der weitere Ätzprozess in einem Ätzschritt erfolgen.

Im letzten Verfahrensschritt wird, wie in Figur 5D dargestellt, der Fotolack 6 entfernt, wobei auf den Stegen 4 eine Anschlussschicht 5 angeordnet wird.

Das Ausführungsbeispiel der Figur 6 unterscheidet sich von der Abwandlung der Figur 4 dadurch, dass die Gräben 3 jeweils eine Grundfläche 31 aufweisen, die jeweils eine Krümmung aufweist. Die Krümmung der Grundfläche 31 ist vorzugsweise jeweils linsenförmig ausgebildet. Insbesondere weisen die Krümmungen der Grundflächen 31 zusammen eine konvexe Linsenform auf.

Die Gräben 3 weisen somit in dem Ausführungsbeispiel der Figur 6 eine unterschiedliche Tiefe auf. Insbesondere wird die Breitstreifenstruktur in mehrere gleich breite, äquidistante Stege 4 aufgespalten, wobei die indexdefinierende Ätztiefe zwischen den Stegen geringer ist als außerhalb des ursprünglichen Breitstreifens, um der stärkeren Facettenbelastung der mittleren Stege durch eine höhere Stromaufweitung entgegenzuwirken. Der Ätztiefenunterschied verläuft in diesem Fall vorzugsweise graduell.

In den Figuren 7A bis 7D sind Herstellungsschritte eines Breitstreifenlasers gemäß dem Ausführungsbeispiel der Figur 6 dargestellt.

Wie in Figur 7A dargestellt, ist auf den Schichtenstapel 2, insbesondere auf der Oberseite 22 des Schichtenstapels 2, eine Ätzhilfsmaske 8 aufgebracht. Auf der Ätzhilfsmaske 8 ist ein Fotolack 7 angeordnet, der durch eine thermische Behandlung vorzugsweise verfließt. Durch den verfließenden Fotolack kann eine linsenförmige Struktur der Ätzhilfsmaske hergestellt werden. Insbesondere wird so die Ätzhilfsmaske linsenförmig strukturiert, wie in Figur 7B dargestellt. Diese Strukturierung erfolgt vorzugsweise mittels einer trockenchemischen Übertragung auf die Ätzhilfsmaske 8.

Im nächsten Verfahrensschritt wird, wie in Figur 7C dargestellt, eine streifenförmige Lackstruktur 6 auf die linsenförmige Ätzhilfsmaske 8 aufgebracht. Anschließend wird mittels eines weiteren Ätzprozesses eine Einzelstreifenstruktur mit gradueller Indexführung ausgebildet, wie in Figur 7D dargestellt. Insbesondere werden so in dem Schichtenstapel 2 oberseitig Stege 4 und Gräben 3 ausgebildet, wobei die Gräben 3 eine Grundfläche 31 mit jeweils einer Krümmung aufweisen.

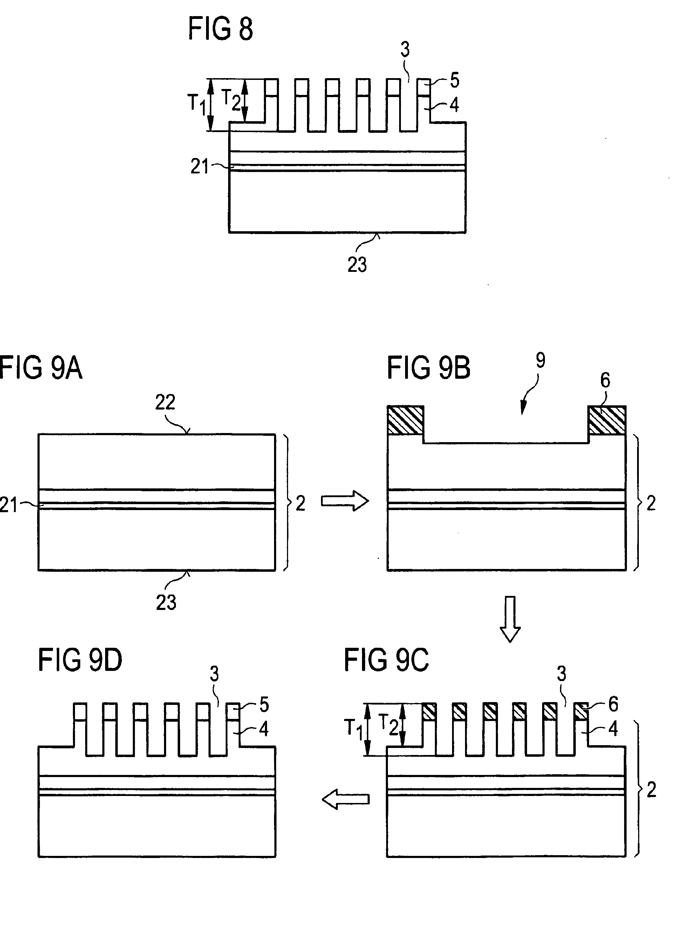

Die Abwandlung der Figur 8 unterscheidet sich von der Abwandlung der Figur 4 dadurch, dass die Gräben 3 eine größere Tiefe, insbesondere eine größere Ätztiefe T₁ aufweisen als die Breitstreifenstruktur des Lasers (Tiefe T₂). Insbesondere wird die Breitstreifenstruktur in mehrere gleich breite, äquidistante Stege 4 aufgespalten, wobei die indexdefinierende Ätztiefe T₁ zwischen den Stegen 4 graduell oder stufenförmig höher ist als außerhalb des ursprünglichen Breitstreifens, wodurch über die ätztiefenabhängige Steilheit mit Vorteil gezielt das Strahlprofil des Lasers gesteuert werden kann.

In den Figuren 9A bis 9D sind jeweils Herstellungsschritte zur Herstellung eines Breitstreifenlasers gemäß der Abwandlung der Figur 8 dargestellt.

Ähnlich wie in den Abwandlungen der Figuren 5A bis 5D findet hierbei ein mehrstufiger Ätzprozess Anwendung. Auf den Schichtenstapel 2 wird im Randbereich ein Fotolack 6 aufgebracht, siehe Figur 9B, wobei hier ein erster Ätzprozess stattfindet, der einen ersten Ätzbereich 9 oberseitig des Schichtenstapels 2 ausbildet. Anschließend wird eine streifenförmige Lackstruktur in Bereichen des ersten Ätzprozesses 9 auf die Oberseite 22 des Schichtenstapels 2 aufgebracht, wobei anschließend ein zweiter Ätzprozess stattfindet, der Gräben 3 in die Oberseite 22 des Schichtenstapels 2 ätzt. Dabei werden die Gräben 3 im Unterschied zu der Abwandlung der Figuren 5A bis 5d derart tief geätzt, dass die Ätztiefe T₁ höher ist als die Ätztiefe T₂ der Breitstreifenstruktur, siehe Figur 9C. Im nächsten Verfahrensschritt wird die streifenförmige Lackstruktur 6 entfernt, wobei eine Anschlussschicht 5 jeweils auf die Stege 4 aufgebracht wird, siehe Figur 9D.

Die Abwandlung der Figur 10 unterscheidet sich von der Abwandlung der Figur 1 dadurch, dass die Stege 4 eine unterschiedliche Breite b₁, b₂ aufweisen. Vorzugsweise weisen innere Stege eine größere Breite b₁ auf als äußerer Stege (Breite b₂).

Der Breitstreifenlaser gemäß der Abwandlung der Figur 10 weist somit mehrere äquidistante, gleich tief geätzte, unterschiedlich breite Stege 4 auf, wodurch einem unterschiedlichen Anschwingen, das bedingt ist durch eine unterschiedliche thermische Belastung, mit Vorteil entgegengewirkt werden kann. Dadurch kann mit Vorteil das Strahlprofil des Lasers gezielt beeinflusst werden.

Die Abwandlung der Figur 11 unterscheidet sich von der Abwandlung der Figur 1 dadurch, dass die Anschlussschicht 51, 52, die jeweils auf den Stegen 4 angeordnet ist, strukturiert ist. Insbesondere weist die Anschlussschicht 51, 52 im Unterschied zu der in Figur 1 dargestellten Anschlussschicht eine entlang des jeweiligen Steges 4 geführte Öffnung 5c auf. Die Anschlussschicht 51, 52 auf den jeweiligen Stegen 4 ist demnach streifenförmig ausgebildet, wobei in diesem Fall die Anschlussschicht 51, 52 zwei auf den Stegen 4 seitlich angeordnete Streifen 51, 52 aufweist. Zwischen den Streifen 51, 52 ist die Öffnung 5c der Anschlussschicht ausgebildet, sodass bereichsweise auf den Stegen 4 keine Anschlussschicht 51, 52 angeordnet ist, insbesondere im mittleren Bereich der Stege 4.

Die Anschlussschicht 51, 52 setzt sich somit vorzugsweise aus gewinngeführten Streifen, insbesondere Metallisierungsstreifen, zusammen.

Eine Aufsicht auf eine derartig ausgebildete Anschlussschicht ist beispielsweise in Figur 13C dargestellt. Der Steg 4 weist seitlich zwei Anschlussschichten 51, 52 auf, die entlang des Steges 4 geführt sind und insbesondere durchgezogen sind. Mittig entlang des Steges 4 ist keine Anschlussschicht angeordnet.

Die Abwandlung der Figur 12 unterscheidet sich von der Abwandlung der Figur 11 dadurch, dass die Stege bereichsweise, insbesondere in den Bereichen, in denen keine Anschlussschicht 5 aufgebracht ist, weitere Ätztiefen aufweisen. Die Anschlussschicht 5 ist insbesondere jeweils an einem seitlichen Bereich der Stege 4 angeordnet, sodass die weiteren Ätztiefen mittig der Stege 4 ausgebildet sind. Die Ätztiefen führen vertikal insbesondere nicht vollständig durch die Stege 4 hindurch.

In den Ausführungsbeispielen der Figuren 13A bis 13C ist jeweils eine Aufsicht auf einen Steg 4 dargestellt. Insbesondere zeigen die Ausführungsbeispiele der Figuren 13A bis 13C jeweils zusätzliche Modifizierungen der Anschlussschicht 5.

In Figur 13A ist die Anschlussschicht 5 als nicht vollständig durchgezogene Anschlussschicht ausgebildet. Insbesondere ist die Anschlussschicht 5 auf den Stegen 4 jeweils als von zwei sich gegenüberliegenden Kanten 5a, 5b der Stege 4 zurückgezogene Anschlussschicht 5 ausgebildet. Die Stege 4 weisen demnach im Kantenbereich 5a, 5b keine Anschlussschicht 5 auf. Dadurch können gezielt Bereiche mit einer höheren Absorption erzeugt werden.

Das Ausführungsbeispiel der Figur 13B unterscheidet sich von dem Ausführungsbeispiel der Figur 13A dadurch, dass die Anschlussschicht 5 Öffnungen 5c aufweist. Insbesondere weist die Anschlussschicht 5 mehrere Öffnungen 5c quer zum Steg 4 auf.

Im Unterschied dazu weist das Ausführungsbeispiel der Figur 13C eine Öffnung 5c entlang des Steges 4 auf. Die Anschlussschicht 5 ist demnach in zwei Streifen 51, 52 aufgespalten, die sich entlang des Steges 4 erstrecken.

Alternativ zu einer Anschlussschicht 5, die Öffnungen 5c aufweist, kann zwischen der Anschlussschicht 5 und den Stegen 4 eine Passivierungsschicht angeordnet sein (nicht dargestellt). Die Passivierungsschicht ist insbesondere elektrisch isolierend, sodass die Anschlussschicht 5 ganzflächig ausgebildet sein kann, wobei der elektrische Kontakt zwischen Anschlussschicht 5 und Steg 4 mittels der Passivierungsschicht nicht ganzflächig ausgebildet ist. Insbesondere findet in Bereichen der Passivierungsschicht kein elektrischer Kontakt zwischen Anschlussschicht 5 und Steg 4 statt. Beispielsweise enthält die Passivierungsschicht Siliziumdioxid (SiO₂), Siliziumnitrid (SiN), Aluminiumoxid (Al₂O₃), Hafniumoxid (HfO₂), Zirconiumoxid (ZrO₂) oder Tantaloxid (Ta₂O₅).

Ferner kann eine Mehrzahl von Breitstreifenlasern gemäß den Ausführungsbeispielen der Breitstreifenlaser der Figuren 1, 3, 4, 6, 8, 10, 11 oder 12 nebeneinander als voneinander getrennte Arrays angeordnet ein, wobei die Abstände zwischen benachbarten Arrays jeweils vorzugsweise größer als 20 µm sind (nicht dargestellt).

## Patentansprüche

1. Breitstreifenlaser (1) mit einem epitaktischen Schichtenstapel (2), der eine aktive, strahlungserzeugende Schicht (21) enthält und eine Oberseite (22) und eine Unterseite (23) aufweist, wobei
- der Breitstreifenlaser (1) eine Breitstreifenstruktur mit einem oberseitig angeordneten Breitstreifen aufweist,
- der Schichtenstapel (2) Gräben (3) aufweist, in denen wenigstens eine Schicht des Schichtenstapels (2) zumindest teilweise entfernt ist und die von der Oberseite (22) in Richtung Unterseite (23) führen,
- der Schichtenstapel (2) oberseitig Stege (4) aufweist, die jeweils an die Gräben (3) angrenzen, sodass der Schichtenstapel (2) oberseitig streifenförmig ausgebildet ist und sodass der Breitstreifen in indexgeführte, benachbarte Einzelstreifen, den Stegen (4), aufgespalten ist,
- der Breitstreifenlaser (1) ein Kantenemitter ist, und
- die Stege (4) und die Gräben (3) jeweils eine Breite (d₁, d₂) von höchstens 20 µm aufweisen,
**dadurch gekennzeichnet, dass**
die Gräben (3) jeweils eine Grundfläche (31) aufweisen und die Grundfläche (31) jeweils eine Krümmung aufweist.

2. Breitstreifenlaser gemäß Anspruch 1, wobei
zumindest eine Schicht des Schichtenstapels (2) auf der der Unterseite (23) zugewandten Seite der aktiven, strahlungserzeugenden Schicht (21) n-dotiert und zumindest eine Schicht des Schichtenstapels (2) auf der der Oberseite (22) zugewandten Seite der aktiven, strahlungserzeugenden Schicht (21) p-dotiert ist und die Gräben (3) in der p-dotierten Schicht oder den p-dotierten Schichten des Schichtenstapels (2) ausgebildet sind.

3. Breitstreifenlaser gemäß einem der vorhergehenden Ansprüche, wobei
der Schichtenstapel auf dem InGaAlN-Materialsystem basiert.

4. Breitstreifenlaser gemäß einem der vorhergehenden Ansprüche, wobei
die Gräben (3) die aktive Schicht durchdringen.

5. Breitstreifenlaser gemäß einem der vorhergehenden Ansprüche, wobei
die Stege (4) eine Breite (d₁) von weniger als 7 µm aufweisen und benachbarte Stege (4) einen Abstand (d₂) von höchstens 10 µm zueinander aufweisen.

6. Breitstreifenlaser gemäß einem der vorhergehenden Ansprüche, wobei
die Gräben (3) zumindest teilweise eine unterschiedliche Tiefe aufweisen.

7. Breitstreifenlaser gemäß einem der vorhergehenden Ansprüche, wobei
benachbarte Stege (4) jeweils in einem gleichen Abstand zueinander angeordnet sind.

8. Breitstreifenlaser gemäß einem der vorhergehenden Ansprüche 1 bis 6, wobei
benachbarte Stege (4) zumindest teilweise in einem unterschiedlichen Abstand zueinander angeordnet sind, wobei benachbarte innere Stege (4a) einen größeren Abstand zueinander aufweisen als benachbarte äußere Stege (4b).

9. Breitstreifenlaser gemäß einem der vorhergehenden Ansprüche, wobei
die Stege (4) zumindest teilweise eine unterschiedliche Breite (b₁, b₂) aufweisen.

10. Breitstreifenlaser gemäß einem der vorhergehenden Ansprüche, wobei
die Grundflächen (31) der Gräben (3) zusammen eine konvexe Linsenform ausbilden.

11. Breitstreifenlaser gemäß einem der vorhergehenden Ansprüche, wobei
jeweils auf den Stegen (4) zumindest bereichsweise eine Anschlussschicht (5) angeordnet ist.

12. Breitstreifenlaser gemäß Anspruch 11, wobei
die Anschlussschicht (5) auf den Stegen (4) jeweils als von zwei sich gegenüberliegenden Kanten (5a, 5b) des Schichtenstapels (2) zurückgezogene Anschlussschicht (5) ausgebildet ist.

13. Breitstreifenlaser gemäß Anspruch 11 oder 12, wobei
die Anschlussschicht (5) auf den Stegen (4) jeweils als mit einer oder mehrerer Öffnungen (5c) versehene Anschlussschicht (5) ausgebildet ist.

14. Breitstreifenlaser gemäß einem der vorhergehenden Ansprüche 11 bis 13, wobei
zwischen den Stegen (4) und der Anschlussschicht (5) bereichsweise eine Passivierungsschicht angeordnet ist.

15. Verfahren zum Herstellen eines Breitstreifenlasers (1) nach einem der vorhergehenden Ansprüche, aufweisend die folgenden Verfahrensschritte:
- Epitaktisches Aufwachsen eines Schichtenstapels (2) auf einem Aufwachssubstrat, wobei der Schichtenstapel (2) eine Oberseite (22) und eine Unterseite (23) aufweist,
- Oberseitiges Ätzen des Schichtenstapels (2) an zwei sich gegenüberliegenden Kanten (24a, 24b) des Schichtenstapels (2) derart, dass eine Breitstreifenlaser-Struktur ausgebildet wird,
- Oberseitiges Ätzen von Gräben (3) in den Schichtenstapel (2) im Bereich der Breitstreifenlaser-Struktur derart, dass Stege (4) ausgebildet werden, die jeweils eine Breite (d₁) von höchstens 20 µm aufweisen, wobei benachbarte Stege (4) einen Abstand (d₂) von höchstens 20 µm zueinander aufweisen.

## Claims

1. A broad stripe laser (1) comprising an epitaxial layer stack (2), which contains an active, radiation-generating layer (21) and has a top side (22) and an underside (23), wherein
- the broad stripe laser (1) has a broad stripe structure having a broad stripe arranged on the top side,
- the layer stack (2) has trenches (3) in which at least one layer of the layer stack (2) is at least partly removed and which lead from the top side (22) in the direction of the underside (23),
- the layer stack (2) has on the top side ridges (4) each adjoining the trenches (3), such that the layer stack (2) is embodied in striped fashion on the top side, and such that the broad stripe is split into index-guided adjacent individual stripes, the ridges (4),
- the broad stripe laser (1) is an edge emitter, and
- the ridges (4) and the trenches (3) respectively have a width (d₁, d₂) of at most 20 µm **characterized in that** the trenches (3) each have a base area (31) and the base area (31) has a curvature in each case.

2. Broad stripe laser according to Claim 1, wherein
at least one layer of the layer stack (2) on that side of the active, radiation-generating layer (21) which faces the underside (23) is n-doped and at least one layer of the layer stack (2) on that side of the active, radiation-generating layer (21) which faces the top side (22) is p-doped and the trenches (3) are formed in the p-doped layer or the p-doped layers of the layer stack (2).

3. Broad stripe laser according to either of the preceding claims, wherein
the layer stack is based on the InGaAlN material system.

4. Broad stripe laser according to any of the preceding claims, wherein
the trenches (3) penetrate through the active layer.

5. Broad stripe laser according to any of the preceding claims, wherein
the ridges (4) have a width (d₁) of less than 7 µm and adjacent ridges (4) have a distance (d₂) from one another of at most 10 µm.

6. Broad stripe laser according to any of the preceding claims, wherein
the trenches (3) have a different depth at least in part.

7. Broad stripe laser according to any of the preceding claims, wherein
adjacent ridges (4) are in each case arranged at an identical distance from one another.

8. Broad stripe laser according to any of the preceding Claims 1 to 6, wherein
adjacent ridges (4) are arranged at a different distance from one anther at least in part, wherein adjacent inner ridges (4a) are at a greater distance from one another than adjacent outer ridges (4b).

9. Broad stripe laser according to any of the preceding claims, wherein
the ridges (4) have a different width (b₁, b₂) at least in part.

10. Broad stripe laser according to any of the preceding claims, wherein
the base areas (31) of the trenches (3) together form a convex lens shape.

11. Broad stripe laser according to any of the preceding claims, wherein
a connection layer (5) is arranged at least in regions in each case on the ridges (4).

12. Broad stripe laser according to Claim 11, wherein
the connection layer (5) is formed on the ridges (4) in each case as a connection layer (5) drawn back from two opposite edges (5a, 5b) of the layer stack (2).

13. Broad stripe laser according to Claim 11 or 12, wherein
the connection layer (5) is formed on the ridges (4) in each case as a connection layer (5) provided with one or more openings (5c).

14. Broad stripe laser according to any of the preceding Claims 11 to 13, wherein
a passivation layer is arranged in the regions between the ridges (4) and the connection layer (5).

15. Method for producing a broad stripe laser (1) according to any of the preceding claims, comprising the following method steps:
- epitaxial growth of a layer stack (2) on a growth substrate, wherein the layer stack (2) has a top side (22) and an underside (23),
- top-side etching of the layer stack (2) at two opposite edges (24a, 24b) of the layer stack (2) in such a way that a broad stripe laser structure is formed,
- top-side etching of trenches (3) in the layer stack (2) in the region of the broad stripe laser structure in such a way that ridges (4) are formed, each having a width (d₁) of at most 20 µm, wherein adjacent ridges (4) are at a distance (d₂) from one another of at most 20 µm.

## Revendications

1. Laser à bande large (1) comprenant une pile de couches (2) épitaxiale qui contient une couche active génératrice de rayonnement (21) et présente un côté supérieur (22) et un côté inférieur (23),
- le laser à bande large (1) présentant une structure à bande large avec une bande large disposée sur le côté supérieur,
- la pile de couches (2) présentant des tranchées (3) dans lesquelles au moins une couche de la pile de couches (2) est au moins partiellement retirée et qui mènent du côté supérieur (22) en direction du côté inférieur (23),
- la pile de couches (2) présentant des nervures (4) du côté supérieur qui sont respectivement contiguës aux tranchées (3) de sorte que la pile de couches (2) est réalisée en forme de bande sur le côté supérieur et de sorte que la bande large est fractionnée en bandes individuelles voisines indexées, les nervures (4),
- le laser à bande large (1) étant un émetteur par la tranche et
- les nervures (4) et les tranchées (3) présentant respectivement une largeur (d₁, d₂) maximale de 20 µm,
**caractérisé en ce que**
les tranchées (3) présentent respectivement une surface de base (31) et la surface de base (31) présente à chaque fois une courbure.

2. Laser à bande large selon la revendication 1, avec lequel au moins une couche de la pile de couches (2) est dopée n sur le côté faisant face au côté inférieur (23) de la couche active génératrice de rayonnement (21) et au moins une couche de la pile de couches (2) est dopée p sur le côté faisant face au côté supérieur (22) de la couche active génératrice de rayonnement (21) et les tranchées (3) sont formées dans la couche dopée p ou dans les couches dopées p de la pile de couches (2).

3. Laser à bande large selon l'une des revendications précédentes, avec lequel la pile de couches est à base du système de matériau InGaAlN.

4. Laser à bande large selon l'une des revendications précédentes, avec lequel les tranchées (3) traversent la couche active.

5. Laser à bande large selon l'une des revendications précédentes, avec lequel les nervures (4) présentent une largeur (d₁) de moins de 7 µm et les nervures (4) voisines présentent un écart (d₂) maximum de 10 µm entre elles.

6. Laser à bande large selon l'une des revendications précédentes, avec lequel les tranchées (3) présentent au moins partiellement une profondeur différente.

7. Laser à bande large selon l'une des revendications précédentes, avec lequel les nervures (4) voisines sont respectivement disposées avec un espacement mutuel identique.

8. Laser à bande large selon l'une des revendications précédentes 1 à 6, avec lequel les nervures (4) voisines sont disposées au moins partiellement avec un espacement mutuel différent, les nervures intérieures voisines (4a) présentant un espacement mutuel plus grand que les nervures extérieures voisines (4b).

9. Laser à bande large selon l'une des revendications précédentes, avec lequel les nervures (4) présentent au moins partiellement une largeur (b₁, b₂) différente.

10. Laser à bande large selon l'une des revendications précédentes, avec lequel les surfaces de base (31) des tranchées (3) forment ensemble une forme de lentille convexe.

11. Laser à bande large selon l'une des revendications précédentes, avec lequel une couche de raccordement (5) est à chaque fois disposée au moins dans certaines zones sur les nervures (4).

12. Laser à bande large selon la revendication 11, avec lequel la couche de raccordement (5) sur les nervures (4) est à chaque fois réalisée sous la forme d'une couche de raccordement (5) en retrait de deux arêtes (5a, 5b) opposées de la pile de couches (2).

13. Laser à bande large selon la revendication 11 ou 12, avec lequel la couche de raccordement (5) sur les nervures (4) est à chaque fois réalisée sous la forme d'une couche de raccordement (5) munie d'une ou de plusieurs ouvertures (5c).

14. Laser à bande large selon l'une des revendications précédentes 11 à 13, avec lequel une couche de passivation est disposée dans certaines zones entre les nervures (4) et la couche de raccordement (5).

15. Procédé de fabrication d'un laser à bande large (1) selon l'une des revendications précédentes, présentant les étapes suivantes :
- croissance épitaxiale d'une pile de couches (2) sur un substrat de croissance, la pile de couches (2) présentant un côté supérieur (22) et un côté inférieur (23),
- gravure par corrosion sur le côté supérieur de la pile de couches (2) sur deux arêtes opposées (24a, 24b) de la pile de couches (2) de manière à former une structure de laser à bande large,
- gravure par corrosion sur le côté supérieur de tranchées (3) dans la pile de couches (2) dans la zone de la structure de laser à bande large de manière à former des nervures (4) qui présentent respectivement une largeur (d₁) maximale de 20 µm, les nervures (4) voisines présentant un écart (d₂) maximum de 20 µm entre elles.
